(19) **Europäisches Patentamt**

**European Patent Office**

**Office européen des brevets**

(11) **EP 0 462 599 B1**

(12) **EUROPEAN PATENT SPECIFICATION**

(45) Date of publication and mention
of the grant of the patent:
**14.02.1996 Bulletin 1996/07**

(51) Int Cl.⁶: **G01B 11/06**

(21) Application number: **91110089.9**

(22) Date of filing: **19.06.1991**

(54) **Apparatus and method for etch rate monitoring**

Vorrichtung und Verfahren zum Messen der Ätzgeschwindigkeit

Appareil et méthode pour mesurer la vitesse de décapage

(84) Designated Contracting States:
**DE FR GB IT NL**

(30) Priority: **19.06.1990 US 540660**

(43) Date of publication of application:
**27.12.1991 Bulletin 1991/52**

(73) Proprietor: **APPLIED MATERIALS, INC.**
**Santa Clara, California 95054-3299 (US)**

(72) Inventors:
• **Strul, Bruno**
**Palo Alto, CA 94306 (US)**
• **de Geus, Richard**
**Cupertino, CA 95014 (US)**
• **Ebbing, Peter**
**Los Altos, CA 94024 (US)**

(74) Representative:
**DIEHL GLAESER HILTL & PARTNER**
**D-80603 München (DE)**

(56) References cited:
**EP-A- 0 352 740**          **US-A- 4 873 430**

• PATENT ABSTRACTS OF JAPAN vol. 11, no.
088 (E-490), 18 March 1987 & JP-A-61 241 923
• PATENT ABSTRACTS OF JAPAN vol. 10, no.
008 (E-373), 14 January 1986 & JP-A-60 173 837

## Description

This invention relates to techniques for monitoring etch rate on semiconductor or other wafers during processing in an etch chamber and especially to an etch rate monitor.

Conventional approaches to etch rate monitoring for semiconductor wafers during processing illuminate the repetitive patterns on the wafers through windows into the etch chambers and use photodetector devices to monitor changes in diffraction patterns from repetitive features. Such conventional devices are extremely pattern dependent and therefore relatively complicated to set-up, maintain and use. Such conventional devices are quite sensitive to alignment, do not provide satisfactory penetration deep into small features and have poor signal to noise ratio because only a few diffraction orders are collected and processed.

EP-A2-0 352 740 relates to a laser interferometer system and method for monitoring and controlling 1C processing. This document teaches to position incoming light in the middle of the chamber window. This has the disadvantage that only first order diffracted light on all sides of the incident beam is collected. Furthermore, interfering light deteriorates the measuring results.

The preceding and other shortcomings of the prior art are addressed and overcome by the present invention that provides an etch rate monitor for wafer processing, according to independent claim 1 and a method of monitoring the etch rate according to independent claim 7. Further advantageous features and details of the invention are evident from the dependent claims, the description and the drawings. The claims are intended to be understood as a first non-limiting approach of defining the invention in general terms.

The invention therefore provides an etch rate monitor for wafer processing, having means for applying a collimated light beam of normal incidence to the surface of a masked wafer in an etch chamber, means for collecting light diffracted therefrom, and means for monitoring the etch rate in the chamber in accordance with the time varying intensity of the collected light.

In another aspect, the present invention provides a method for monitoring etch rate during wafer processing by applying a collimated light beam of normal incidence to the surface of a masked wafer being processed, collecting light diffracted therefrom and monitoring the etch rate in accordance with the time varying intensity of the collected light.

These and other features and advantages of this invention will become further apparent from the detailed description that follows which is accompanied by a set of drawing figures. In the figures and description, numerals indicate the various features of the invention, like numerals referring to like features throughout both the drawings and the description.

**Fig. 1** is an illustration of a portion of an etch chamber and an etch rate monitor associated therewith in accordance with the present invention in which a lens system is used for collecting diffraction orders.

**Fig. 2** is an illustration of a portion to be etched of the semiconductor wafer shown in **Fig. 1**.

**Fig. 3** is an illustration of another embodiment of the present invention in which a concave mirror is used for collecting diffraction orders.

**Fig. 4** is an illustration of another embodiment of the present invention in which a photodetector is used directly for collecting diffraction orders.

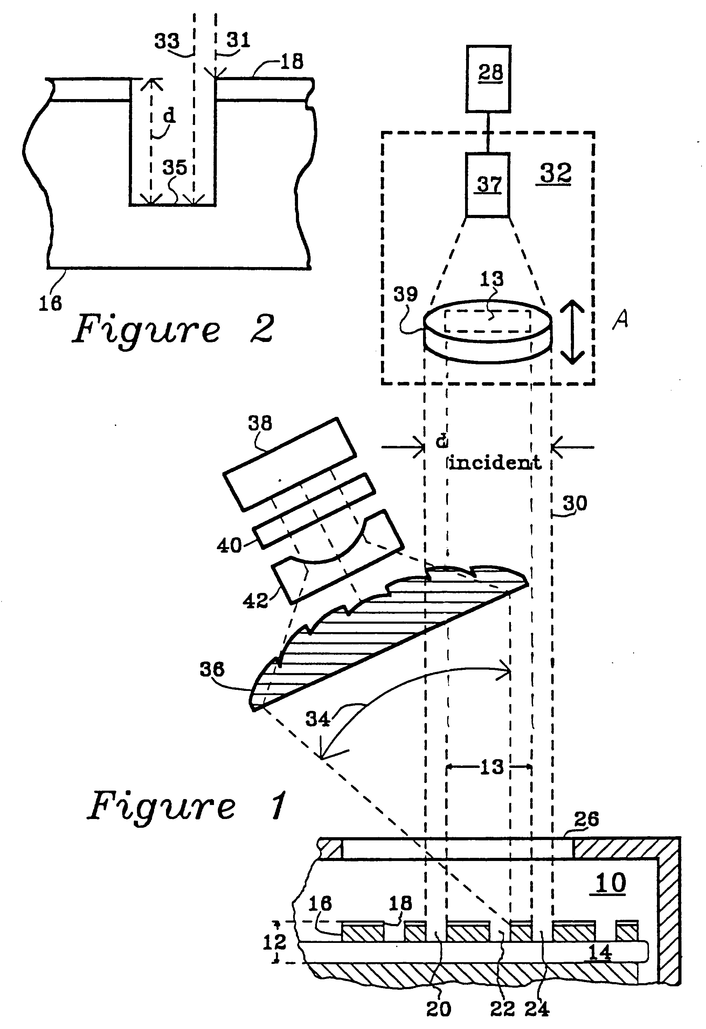

**Fig. 1** is an illustration of a portion of etch chamber **10** including semiconductor wafer **12**. There are many etching processes in which different materials are etched or protected by resist or mask or resist-mask, but the following description will serve as a common example thereof in order to properly describe the present invention.

Semiconductor wafer **12** is formed of silicon crystal base **14** on which is grown a layer of material, such as silicon dioxide **16**, to be etched during processing in etch chamber **10**. A pattern of etch resistant material, such as resist pattern **18**, is formed in a desired, repetitive masking pattern on a layer to be etched, such as silicon dioxide layer **16**. The repetitions of the masking pattern represent portions of semiconductor wafer **12** to be separated in a subsequent process into separate semiconductor dies, such as die **13**. During operation of etch chamber **10**, an etching process, not shown, is used to etch away and remove portions of silicon dioxide layer **16**, such as portions **20**, **22** and **24**, which are not protected by resist pattern **18**. The system can also be used for monitoring the etch rate of other wafer processes including single crystal and recessed polysilicon processes.

An important operating consideration during this etching process is the depth of the etch. Although great care and planning goes into attempting to predetermine the total etching depth required to remove exactly the amount of material desired to be removed, it is still very important to actually monitor the depth of the etch to stop the etching process at the proper time for the wafer being processed to provide a good yield of properly etched wafers.

Etch chamber **10** includes window **26** through which the etching processes may be viewed. In accordance with the present invention, light source **28** provides incident collimated light beam **30** whose diameter, $d_{incident}$, is preferably slightly larger than the largest dimension of die **13**. If, for example, die **13** is a rectangular die, $d_{incident}$ should be only slightly larger than the diagonal dimension of die **13** in order not to compete with the collection of the diffraction orders emerging from window **26**.

That is, as $d_{incident}$ is increased in diameter, the opening, not shown, through collection optics **36** through which $d_{incident}$ must pass must be increased. This results in a reduction of the useful area of collection optics **36** and therefore a reduction in the diffraction orders which may be collected thereby.

Light source **28**, and associated light source optics **32**, are mounted with respect to etch chamber **10** so that collimated light beam **30** passes through the opening in collection optics **36** discussed above and is of normal incidence to the surface of semiconductor wafer **12**. Incident collimated light beam **30** preferably enters window **26** close to its perimeter in order to maximize the collection of diffraction orders.

Light source optics **32** includes stressed fiber beam homogenizer **37** positioned between light source **28**, which may conveniently be an optical laser, and variable focal length collimating lens **39** so that the light in incident collimated light beam **30** may be made as uniform as possible. The diameter of incident collimated light beam **30** may be adjusted by moving variable focal length collimating lens **39** with respect to stressed fiber beam homogenizer **37** as indicated by arrow A.

Repetitive resist pattern **18** serves as a diffraction grating and reflects many diffraction orders as a result of incident collimated light beam **30**. Many diffraction orders emerge from window **26**. Several such diffraction orders emerge through window **26** along reflection path **34** to collection optics **36** as will be discussed below with reference to **Fig. 2**. Semiconductor wafer **12** should be positioned as close as possible to window **26** to allow at least one quadrant of the diffraction orders to emerge from window **26**.

Collection optics **36** is a large diameter, short focal length lens, such as a Fresnel lens or a positive lens, not shown, in order to collect as many diffraction orders as possible. The positive lens would provide better quality diffracted light to detector **38** than a Fresnel lens which tends to scatter light because of its construction. The positive lens however, would'have to be very thick and therefore both heavy and cumbersome. In addition, the very thickness of the lens would result in partial attenuation of absorbed light. The Fresnel lens is thinner and easier to work with, but the resultant light scattering may not be acceptable for some applications. Alternate embodiments are shown in **Fig.s** 3 and **4**, below, which reduce these problems.

Collection optics **36** includes a hole or other opening for permitting incident collimated light beam **30** to reach semiconductor wafer **12** without obstruction. Collection optics **36** serves to redirect diffraction orders emerging along reflection path **34** to detector **38**, positioned along the optical axis of collection optics **36**. Detector **38** may be conventional photodetection apparatus and is used, with electronic systems not shown, for monitoring etch rate in etch chamber **10**.

During operation, the etch rate, **R**, may be determined by monitoring the intensity of the collected portion of the light diffracted by resist pattern **18**. This intensity varies in a repeating pattern as a function of etching depth. As will be discussed in greater detail below with reference to **Fig. 2**, the light intensity varies from a maxima to a minima every time the depth of the etch, called feature depth **d**, increases by one half wavelength of incident light.

With reference now to **Fig. 2**, collimated light beam **30** is of normal incidence to resist pattern **18**. The etching process causes etched surface **35** of silicon dioxide layer **16**, to be etched away and recede further and further below the surface of resist pattern **18**. Etching therefore increases the length of the path from light source **28** to etched surface **35**, represented by ray **33**. The path length of light source **28** to pattern **18** is represented by ray **31** and will not change as a result of the etching process. The length of ray **33** will therefore exceed the length of ray **31** by feature depth **d**.

When the path length difference between ray **31** and ray **33** is equal to odd multiples of half the wavelength of incident collimated light beam **30**, these rays will reach detector **38** 180° out of phase with each other and destructively interfere. Destructive interference results in a detectable reduction of intensity as monitored by detector **38**. When the path length difference between ray **31** and ray **33** is equal to even multiples of half the wavelength of incident collimated light beam **30**, these rays will reach detector **38** exactly in phase with each other and constructively interfere. Constructive interference results in a detectably greater light intensity than destructive interference as monitored by detector **38**.

The intensity monitored by detector **38** therefore exhibits maxima and minima resulting from constructive and destructive interference every time feature depth **d** changes by Δd, an amount of etch depth equal to one half wavelength of the incident light, $\lambda$, as follows:

$$\Delta d = \lambda / 2.$$

Etch rate **R** is the rate of change of feature depth **d** as a function of time and may be determined by monitoring cycle period **T**, the time between occurrences of light intensity maxima or minima, as determined by detector **38**. Each cycle period **T** represents a change of depth equal to one half wavelength of incident collimated light beam **30**. It may be convenient, for example, to monitor the cycle period **T** between light intensity minima. Etch rate **R** may then be determined from the wavelength of incident collimated light beam **30** and cycle period **T**, as follows:

$$R = \Delta d / T = \lambda / 2 T.$$

Improvements in the accuracy of the etch rate monitoring information determined by detector **38** can be achieved by the inclusion of interference filter **40** between collection optics **36** and detector **38** to reject plasma light, ambient light and other sources of light which add noise and reduce monitoring accuracy. Interference filter **40** requires the light beam to be of normal incidence. For this purpose, collimating lens **42** is placed between collection optics **36** and interference filter **40**. Collimating lens **42** may conveniently be a plano-concave lens with a negative focal point.

In addition, it is desirable to select light source **28** so that the smallest convenient wavelength light may be used in order to most easily monitor the smallest possible change in feature depth.

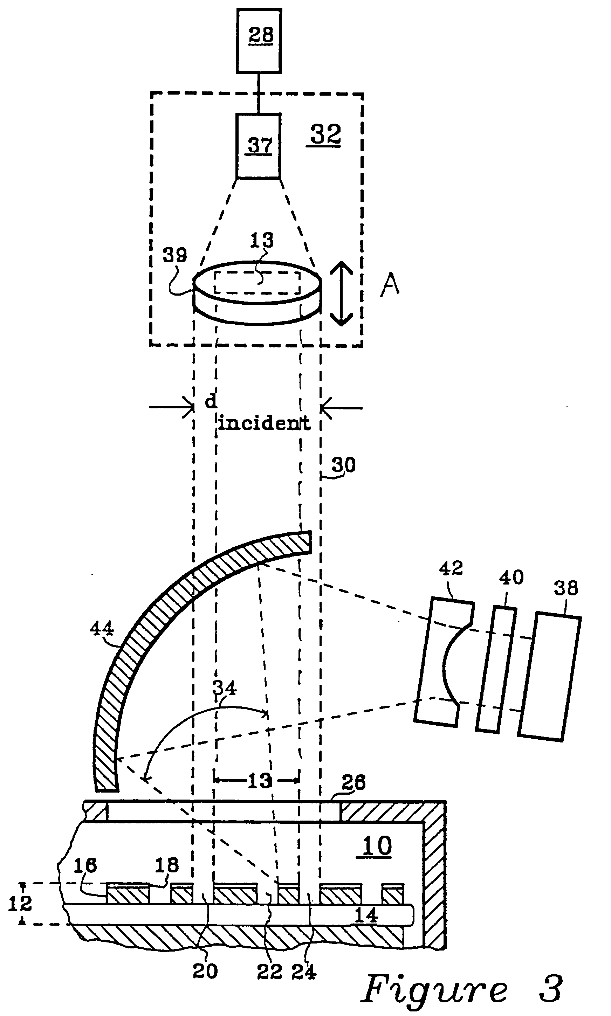

Fig. 3 is an illustration of an etch rate monitor in accordance with the present invention in which reflective optical system, such as concave spherical mirror **44**, is used in lieu of collection optics **36**, shown in **Fig. 1**, to converge the diffracted light from semiconductor wafer **12** onto collimating lens **42**, interference filters **40** and detector **38**. Concave mirror **44** is provided with an opening, not shown, which permits unobstructed passage of incident collimated light beam **30** from light source optics **32** through window **26** to semiconductor wafer **12**. Spherical concave mirror **44** provides the same quality of light collection as a positive lens used as collection optics **36** as shown in **Fig. 1** and substantially superior quality of light collection than a Fresnel lens would under the same circumstances.

In addition, concave mirror **44** does-not have the attenuation and losses associated with a very thick positive lens, nor the weight. Because concave mirror **44** permits the diffraction orders to be redirected by reflection to collimating lens **42**, interference filters **40** and detector **38**, these devices may be mounted closer to etch chamber **10** making the resultant device more compact and enclosable.

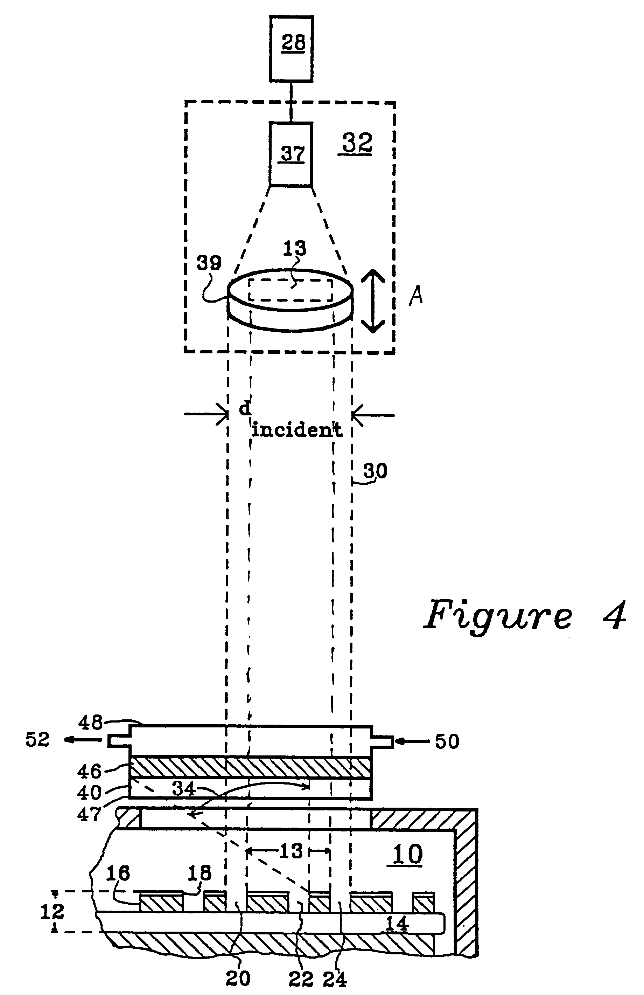

Fig. 4 is an illustration of still another embodiment of an etch rate monitor in accordance with the present invention in which photodetector **46** is used in lieu of collection optics **36**, shown in **Fig. 1**, or concave mirror **44**, shown in **Fig. 3**, to collect and detect the diffracted light from semiconductor wafer **12**. Interference filters **40** may conveniently be positioned between photodetector **46** and window **26**.

Heat transfer requirements for photodetector **46** and/or etch chamber **10** may be conveniently handled by positioning heat exchanger **48** on the surface of photodetector **46** opposite interference filters **40**. Heat exchanger **48** may be a liquid cooled heat exchanger ensuring consistent performance of photodetector **46** and be provided with coolant in flow port **50** and out flow port **52**.

Photodetector **46**, and heat exchanger **48**, must be provided with an opening, not shown, which permits unobstructed passage of incident collimated light beam **30** from light source optics **32** through window **26** to semiconductor wafer **12**. Interference filters **40** permit passage of light with the wavelengths in incident collimated light beam **30** and reject light with wavelengths different therefrom so that an opening within interference filters **40** for passage of incident collimated light beam **30** is not required.

Photodetector **46** may be a single photodetector or an array of such photodetectors, depending upon the application. The advantages of photodetector **46** over concave mirror **44** shown in **Fig. 2** or collection optics **36** shown in **Fig. 1** are simplicity, compactness and convenience. In order to improve the diffraction order collection capability of photodetector **46**, it may be desirable to mount photodetector **46** at some predetermined angle, rotated about an axis such as axis **47**, so that diffraction orders may be detected more normal to the surface of photodetector **46**.

## Claims

1. Using an etch rate monitor for monitoring the etch rate of a substrate (14) being etched in an etch chamber (10) including

   a) a light transmissive window (26) in said chamber;

   b) means (28) for directing a collimated light beam through said window (26);

   c) means (36, 44) for collecting reflected light having multiple diffraction order of time varying intensity through said window arranged at a substantial angle to the path of said collimated light;

   d) a photodetector for said reflected light; and

   e) means responsive to the time varying intensity of the collected light for monitoring etch rate in said chamber, characterised by

   applying said collimated light beam through said window near the periphery thereof.

2. The use of the etch rate monitor claimed in claim 1 wherein said etch rate monitor further includes means (36, 44) for directing light diffracted from said substrate (14) towards said photodetector means (38).

3. The use of the etch rate monitor claimed in claim 2 wherein said means for directing light comprises a transmissive lens means (36)

4. The use of the etch rate monitor claimed in claim 2 wherein said means for directing light comprises curved mirror means (44).

5. The use of the etch rate monitor claimed in one of the preceding claims wherein said etch rate monitor has a heat exchanger (48) associated with the photodetector.

6. The use of the etch rate monitor claimed in any one of the preceding claims wherein said etch rate monitor has an interference filter (40) for collecting reflected light and a collimating lens (42) for applying light from the means for directing light to the interference filter.

7. A method of monitoring etch rate during etching of a substrate in a vacuum etch chamber comprising the steps of

a) applying a collimated light beam (30) of normal incidence through a light transmissive window (26) provided in said etch chamber (10);

b) collecting (36, 44) diffracted light having multiple diffraction orders of time varying intensity therefrom and then detecting (38) the intensity of the diffracted light; and

c) detecting changes in the diffracted light intensity to monitor etch rate in the chamber, characterised by applying said collimated light beam proximate to an edge of said window.

8. The method of monitoring etch rate claimed in claim 7 wherein said diffracted light is concentrated prior to detecting its intensity.

9. The method of monitoring etch rate claimed in claim 8 wherein said concentration step uses a transmissive lens (36).

10. The method of monitoring etch rate claimed in claim 8 wherein said concentration step uses a reflective optical system (44).

11. The method of monitoring etch rate claimed in claim 7 wherein the step of collecting diffracted light uses a photodetector (38).

12. The method of monitoring etch rate claimed in claim 11 further including a heat exchange (48) associated with said photodetector.

13. The method of monitoring etch rate claimed in one of claims 7 to 12 wherein the step of concentrating said diffracted light further includes collimating (42) the diffracted light to produce a collimated, diffracted light; and
applying the collimated, diffracted light to an interference filter (40).

**Patentansprüche**

1. Verwendung einer Ätzgeschwindigkeitsüberwachungsvorrichtung zur Überwachung der Ätzgeschwindigkeit eines in einer Ätzkammer (10) geätzten Substrats (14) mit

a) einem lichtdurchlässigen Fenster (26) in der Kammer;

b) einer Einrichtung (28) zum Schicken eines kollimierten Lichtstrahls durch das Fenster (26);

c) einer Einrichtung (36, 44) zum Sammeln von reflektiertem Licht mit Mehrfachbeugungsordnungen zeitlich variierender Intensität durch das Fenster, angeordnet in einem wesentlichen Winkel zum Weg des kollimierten Lichtes;

d) einem Fotodetektor für das reflektierte Licht; und

e) einer auf die zeitlich variierende Intensität des gesammelten Lichtes ansprechende Einrichtung zur Überwachung der Ätzgeschwindigkeit in der Kammer, gekennzeichnet durch

Anwenden des kollimierten Lichtstrahls durch das Fenster in der Nähe von dessen Peripherie.

2. Verwendung der Ätzgeschwindigkeitsüberwachungsvorrichtung gemäß Anspruch 1, wobei die Ätzgeschwindigkeitsüberwachungsvorrichtung des weiteren eine Einrichtung (36, 44) zum Schicken von von dem Substrat (14) gebeugtem Licht zu der Fotodetektoreinrichtung (38) aufweist.

3. Verwendung der Ätzgeschwindigkeitsüberwachungsvorrichtung gemäß Anspruch 2, bei welcher die Einrichtung zum Schicken von Licht eine durchlässige Linseneinrichtung (36) aufweist.

4. Verwendung der Ätzgeschwindigkeitsüberwachungsvorrichtung gemäß Anspruch 2, bei welcher die Einrichtung zum Schicken von Licht eine gekrümmte Spiegeleinrichtung (44) aufweist.

5. Verwendung der Ätzgeschwindigkeitsüberwachungsvorrichtung gemäß einem der vorhergehenden Ansprüche, wobei die Ätzgeschwindigkeitsüberwachungsvorrichtung einen Wärmetauscher (48) in Verbindung mit dem Fotodetektor aufweist.

6. Verwendung der Ätzgeschwindigkeitsüberwachungsvorrichtung gemäß einem der vorhergehenden Ansprüche, wobei die Ätzgeschwindigkeitsüberwachungsvorrichtung einen Interferenzfilter (40) zum Sammeln reflektierten Lichtes und eine Kollimationslinse (42) zur Anwendung von Licht von der Einrichtung zum Schicken von Licht zu dem Interferenzfilter aufweist.

7. Verfahren zur Überwachung der Ätzgeschwindigkeit während des Ätzens eines Substrats in einer Vakuumätzkammer mit folgenden Schritten:

a) Anwendung eines senkrecht einfallenden kollimierten Lichtstrahls (30) durch ein in der Ätzkammer (10) zur Verfügung gestelltes lichtdurchlässiges Fenster (26);

b) Sammeln (36, 44) von gebeugtem Licht mit Mehrfachbeugungsordnungen zeitlich variierender Intensität davon und anschließendes Erfassen (38) der Intensität des gebeugten Lichtes; und

c) Erfassen von Veränderungen der Intensität des gebeugten Lichtes zur Überwachung der Ätzgeschwindigkeit in der Kammer, gekennzeichnet durch Anwendung des kollimierten Lichtstrahls in der Nähe eines Randes des Fensters.

**8.** Verfahren zur Überwachung der Ätzgeschwindigkeit gemäß Anspruch 7, bei dem das gebeugte Licht vor dem Erfassen von dessen Intensität konzentriert wird.

**9.** Verfahren zur Überwachung der Ätzgeschwindigkeit gemäß Anspruch 8, bei dem beim Konzentrationsschritt eine durchlässige Linse (36) zum Einsatz kommt.

**10.** Verfahren zur Überwachung der Ätzgeschwindigkeit gemäß Anspruch 8, bei dem beim Konzentrationsschritt ein Reflexionsoptiksystem (44) zum Einsatz kommt.

**11.** Verfahren zur Überwachung der Ätzgeschwindigkeit gemäß Anspruch 7, bei dem beim Schritt des Sammelns gebeugten Lichtes ein Fotodetektor (38) zum Einsatz kommt.

**12.** Verfahren zur Überwachung der Ätzgeschwindigkeit gemäß Anspruch 11 mit des weiteren einem Wärmetauscher (48) in Verbindung mit dem Fotodetektor.

**13.** Verfahren zur Überwachung der Ätzgeschwindigkeit gemäß einem der Ansprüche 7 bis 12, bei dem der Schritt der Konzentration des gebeugten Lichtes des weiteren eine Kollimierung (42) des gebeugten Lichtes zur Erzeugung eines kollimierten, gebeugten Lichtes umfaßt; sowie Anwenden des kollimierten, gebeugten Lichtes auf einen Interferenzfilter (40).

**Revendications**

**1.** Utilisation d'un dispositif de contrôle de la vitesse de gravure pour contrôler la vitesse de gravure d'un substrat (14) en cours de gravure dans une chambre de gravure (10), lequel dispositif comprend :

a) une fenêtre (26) de transmission de la lumière dans ladite chambre ;

b) des moyens (28) pour diriger un faisceau lumineux collimaté à travers ladite fenêtre (26) ;

c) des moyens (36,44) pour collecter la lumière réfléchie, ayant des ordres de diffraction multiples dont l'intensité varie au cours du temps, à travers ladite fenêtre, lesdits moyens étant disposés selon un angle sensible par rapport au trajet de ladite lumière collimatée ;

d) un photodétecteur pour ladite lumière réfléchie ; et

e) des moyens réagissant à l'intensité, qui varie au cours du temps, de la lumière collectée pour contrôler la vitesse de gravure dans ladite chambre,
caractérisée par l'application dudit faisceau lumineux collimaté à travers ladite fenêtre, à proximité de la périphérie de celle-ci.

**2.** Utilisation d'un dispositif de contrôle de la vitesse de gravure selon la revendication 1, dans laquelle ledit dispositif de contrôle de la vitesse de gravure comprend en outre des moyens (36,44) pour diriger la lumière diffractée depuis ledit substrat (14) vers ledit photodétecteur (38).

**3.** Utilisation d'un dispositif de contrôle de la vitesse de gravure selon la revendication 2, dans laquelle ledits moyens pour diriger la lumière sont constitués par un moyen formant lentille de transmission (36).

**4.** Utilisation d'un dispositif de contrôle de la vitesse de gravure selon la revendication 2, dans laquelle lesdits moyens pour diriger la lumière sont constitués par un moyen formant miroir courbe (44).

**5.** Utilisation d'un dispositif de contrôle de la vitesse de gravure selon l'une des revendications précédentes, dans laquelle ledit dispositif de contrôle de la vitesse de gravure possède un échangeur thermique (48) associé au photodétecteur.

**6.** Utilisation d'un dispositif de contrôle de la vitesse de gravure selon l'une quelconque des revendications précédentes, dans laquelle le dispositif de contrôle de la vitesse de gravure possède un filtre d'interférences (40) pour collecter la lumière réfléchie et une lentille collimatrice (42) pour appliquer au filtre d'interférences la lumière provenant des moyens pour diriger la lumière.

**7.** Procédé de contrôle de la vitesse de gravure au cours de la gravure d'un substrat dans une chambre de gravure sous vide, comprenant les étapes consistant à :

a) appliquer un faisceau lumineux collimaté (30) ayant une incidence normale à travers une fenêtre (26) de transmission de la lumière, ménagée dans ladite chambre de gravure (10) ;

b) collecter (36,44) la lumière diffractée à partir de celle-ci, ayant des ordres de diffraction multiples dont l'intensité varie au cours du temps, puis détecter (38) l'intensité de la lumière diffractée ; et

c) détecter des modifications de l'intensité de la lumière diffractée pour contrôler la vitesse de gravure dans la chambre, caractérisé par l'application dudit faisceau lumineux collimaté à proximité d'un bord de ladite fenêtre.

8. Procédé de contrôle de la vitesse de gravure selon la revendication 7, dans lequel ladite lumière diffractée est concentrée avant de détecter son intensité.

9. Procédé de contrôle de la vitesse de gravure selon la revendication 8, dans lequel ladite étape de concentration utilise une lentille de transmission (36).

10. Procédé de contrôle de la vitesse de gravure selon la revendication 8, dans lequel ladite étape de concentration utilise un système optique de réflexion (44).

11. Procédé de contrôle de la vitesse de gravure selon la revendication 7, dans lequel l'étape consistant à collecter la lumière diffractée utilise un photodétecteur (38).

12. Procédé de contrôle de la vitesse de gravure selon la revendication 11, comprenant en outre un échangeur thermique (48) associé audit photodétecteur.

13. Procédé de contrôle de la vitesse de gravure selon l'une des revendications 7 à 12, dans lequel l'étape consistant à concentrer ladite lumière diffractée comprend en outre le fait de collimater (42) la lumière diffractée pour produire une lumière diffractée collimatée ; et à appliquer la lumière collimatée diffractée à un filtre d'interférences (40).

*Figure 2*

*Figure 1*

*Figure 3*

Figure 4